# EUROPEAN PATENT SPECIFICATION

(11) **EP 3 229 336 B1**
(45) Date of publication and mention of the grant of the patent: **30.09.2020**
(21) Application number: 16819788.7
(22) Date of filing: 05.02.2016
(51) Int. Cl.: H04M 19/00, H02J 7/06, H02J 7/04, H02J 7/00, H02J 7/02

(54) **CHARGING METHOD AND ADAPTER**
LADEVERFAHREN UND ADAPTER
PROCÉDÉ DE CHARGE ET ADAPTATEUR

(43) Date of publication of application: 11.10.2017
(73) Proprietor: GUANGDONG OPPO MOBILE TELECOMMUNICATIONS CORP., LTD., Wusha, Chang'an Dongguan, Guangdong 523860 (CN)
(72) Inventor: ZHANG, Jialiang, Dongguan Guangdong 523860 (CN)
(74) Representative: Romano, Giuseppe
(86) International application number: PCT/CN2016/073679
(87) International publication number: WO 2017/133001

(56) References cited:
- EP-A1- 2 930 589
- EP-A1- 2 980 958
- CN-A- 102 545 360
- CN-A- 103 762 702
- CN-A- 104 810 877
- CN-A- 104 810 879
- CN-U- 202 026 118
- US-A1- 2007 222 416
- US-A1- 2017 250 557

## Description

### TECHNICAL FIELD

The present disclosure generally relates to mobile terminal field, and more particularly, to a charge method, an adapter and a mobile terminal.

### BACKGROUND

Nowadays, mobile terminals (such as smart phones) are more and more favored by customers. However, since the power consumption of the mobile terminal is too large, it is required to charge the mobile terminal frequently.

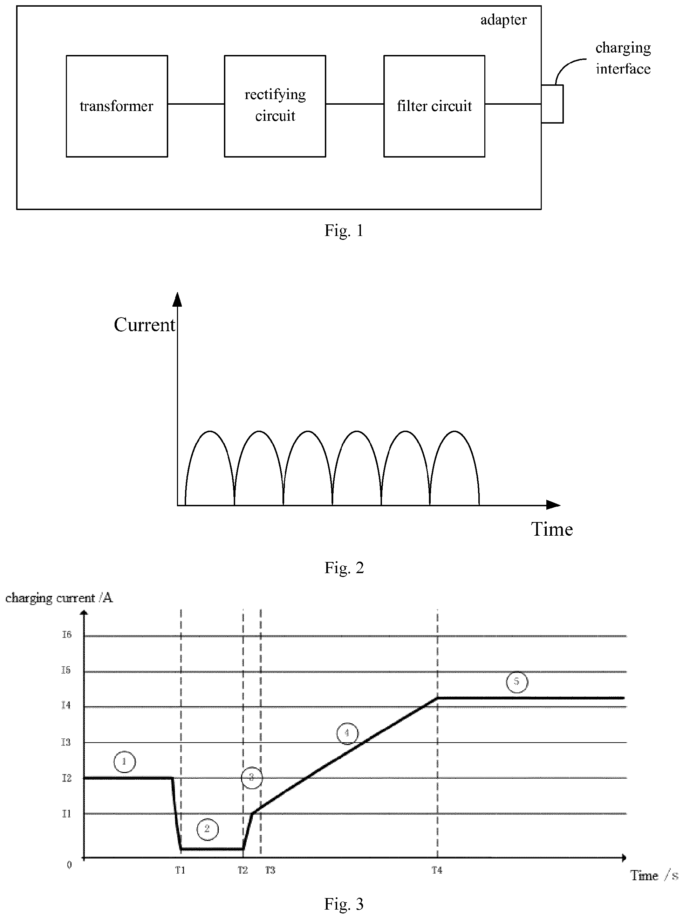

Fig. 1 illustrates a schematic diagram of an internal structure of an adapter. It can be seen from Fig. 1 that, the adapter is typically provided with a transformer, a rectifying circuit and a filter circuit internally. The rectifying circuit may include a primary rectifying circuit and a secondary rectifying circuit. The filter circuit may include a primary filter circuit and a secondary filter circuit. In addition, the adapter may further include a pulse width modulation (PWM) control circuit or other circuits. The transformer may perform a voltage transformation and an isolation on the mains voltage (such as, 220V), so as to convert it to a working voltage (such as, 5V) of the adapter. The filter circuit is typically a bridge circuit, which may convert alternating current having positive and negative directions changed alternately into unidirectional current. That is, after rectification, output current of the rectifying circuit is typically unidirectional pulse current, which may be referred to as steamed buns wave. Fig. 2 illustrates a schematic diagram of a waveform of unidirectional pulse current. The filter circuit filters the voltage and current outputted from the rectifying circuit so as to obtain stable direct current (stable voltage value), and outputs the stable direct current into the mobile terminal via a charging interface so as to charge the battery in the mobile terminal.

An existing mobile terminal is typically supplied with power from a lithium battery. If the battery in the mobile terminal is charged with the above charge method, a lithium precipitation may occur frequently, which causes decreased service life of the battery.

EP2930589A1 relates to a device, system and method for charging a battery. Specifically, the device comprises a USB port, a battery in communication with the USB port and circuity in communication with the USB port and the battery. The circuity is configured to: transmit a power control single over the USB port. The power control signal comprises data indicative of one or more of a power, a voltage and a current to be received over the USB port charge the battery; and, responsively receive the power for charging the battery over the USB port.

EP2980958A1 relates to a charging control method and an electronic device for supporting the same. Specifically, the charging control method includes communicating with a charging device connected to the electronic device, detecting an abnormal charging operation of the charging device, and when the abnormal charging operation is detected, initializing the charing device or an input and output interface of the electronic device connected with the charging device.

### SUMMARY

The present disclosure provides a charge method, as in claim 1, and an adapter, as in claim 8, so as to prolong service life of a battery in a mobile terminal.

In a first aspect, a charge method is provided. The method includes: after an adapter is coupled with a mobile phone via a charging interface (for example, via a universal serial bus (USB) interface), communicating, by the adapter, with the mobile terminal to determine a charging mode, in which a power wire in the charging interface is configured to charge a battery, a data wire in the charging interface is used for communication between the adapter and the mobile terminal, and the charging mode includes a quick charging mode (for example, a charging mode based on a flash charging technique) and a conventional charging mode (for example, standard charge), in which a charging speed in the quick charging mode is greater than that in the conventional charging mode; under a situation of determining to charge the battery in the quick charging mode, communicating, by the adapter, with the mobile terminal to determine a charging current corresponding to the quick charging mode; adopting, by the adapter according to the charging current corresponding to the quick charging mode, a unidirectional pulse output current to perform a quick charge on the battery.

In this solution, the adapter negotiates with the mobile terminal about the charging mode and the charging current of the battery. When determining to charge the battery in the quick charging mode, the adapter adopts the unidirectional pulse output current to perform a quick charge on the battery, based on the negotiated charging current. The current intensity of the unidirectional pulse output current changes periodically. Compared with constant current, the unidirectional pulse output current may reduce the possibility of lithium precipitation and improve service life of the battery. In addition, compared with constant current, the unidirectional pulse output current may reduce the possibility and intensity of electric arc at a contact of the charging interface, and improve service life of the charging interface.

Further, the usage of unidirectional pulse output current may decrease the complexity of the adapter structure and reduce the bulk of the adapter. Specifically, in the related art, in order to acquire stable current, the adapter typically includes a filter circuit. Since an electrolytic capacitor in the filter circuit has a great bulk, the bulk of the entire adapter is large, such that it is inconvenient to carry the adapter. In this solution, since the adapter outputs the unidirectional pulse current rather than constant current, the adapter may directly convert the power after rectification and output the current fluctuating in pulse to the system without the filter circuit, which may simplify the adapter structure.

In addition, the current with changing intensity may relief the heating problem of the adapter during the charging. Compared with constant current, the current with changing intensity is beneficial to reduce polarization effect of the battery, improve the charging speed and reduce the heat emitted from the battery.

In at least one embodiment, adopting, by the adapter according to the charging current corresponding to the quick charging mode, a unidirectional pulse output current to perform a quick charge on the battery may refer to that, the adapter adopts the unidirectional pulse output current to charge the battery in the quick charging mode, according to the charging current corresponding to the quick charging mode.

It should be understood that, the unidirectional pulse output current has features that the direction is constant while the intensity varies over time.

In combination with the first aspect, in a first implementation of the first aspect, before adopting, by the adapter according to the charging current corresponding to the quick charging mode, a unidirectional pulse output current to perform a quick charge on the battery, the method further includes: under a situation that the adapter determines to charge the battery in the quick charging mode, communicating, by the adapter, with the mobile terminal to determine a charging voltage corresponding to the quick charging mode; and adopting, by the adapter according to the charging voltage corresponding to the quick charging mode, a unidirectional pulse output voltage to perform a quick charge on the battery.

In at least one embodiment, adopting, by the adapter according to the charging voltage corresponding to the quick charging mode, a unidirectional pulse output voltage to perform a quick charge on the battery may refer to that, the adapter adopts the unidirectional pulse output voltage to charge the battery in the quick charging mode, according to the charging voltage corresponding to the quick charging mode.

It should be understood that, before the adapter charges the battery in the mobile terminal, the adapter may first negotiate with the mobile terminal about the charging voltage and the charging current corresponding to the quick charging mode. After the charging voltage and the charging current corresponding to the quick charging mode are determined, the adapter may charge the battery according to the negotiated charging voltage and charging current.

In a second aspect, a charge method is provided. The method includes: after a mobile terminal is coupled with an adapter via a charging interface, communicating, by the mobile terminal, with the adapter to determine a charging mode, in which a power wire in the charging interface is configured to charge a battery, a data wire in the charging interface is used for communication between the mobile terminal and the adapter, and the charging mode includes a quick charging mode and a conventional charging mode, in which a charging speed in the quick charging mode is greater than that in the conventional charging mode; under a situation of determining to charge the battery in the quick charging mode, communicating, by the mobile terminal, with the adapter to determine a charging current corresponding to the quick charging mode; and receiving, by the mobile terminal, a unidirectional pulse output current from the adapter so as to perform a quick charge on the battery, in which the unidirectional pulse output current is determined by the adapter according to the charging current corresponding to the quick charging mode.

In combination with the second aspect, in a first implementation of the second aspect, before receiving, by the mobile terminal, a unidirectional pulse output current from the adapter so as to perform a quick charge on the battery, the method further includes: under a situation of determining to charge the battery in the quick charging mode, communicating, by the mobile terminal, with the adapter to determine a charging voltage corresponding to the quick charging mode; and receiving, by the mobile terminal, a unidirectional pulse output voltage from the adapter so as to perform a quick charge on the battery, in which the unidirectional pulse output voltage is determined by the adapter according to the charging voltage corresponding to the quick charging mode.

In a third aspect, an adapter is provided. The adapter includes a communication control circuit and a charging circuit, in which the communication control circuit is configured to communicate with the mobile terminal and to control a charging process between the adapter and the mobile terminal via the charging circuit. The communication control circuit and the charging circuit cooperate with each other to execute the method according to the first aspect.

In a fourth aspect, a mobile terminal is provided. The mobile terminal includes a communication control circuit and a charging circuit. The communication control circuit is configured to communicate with the adapter and to control the charging process between the adapter and the mobile terminal via the charging circuit. The communication control circuit and the charging circuit cooperate with each other to execute the method according to the second aspect.

In a fifth aspect, a charge method is provided. The method includes: after an adapter is coupled with a mobile terminal via a charging interface, adopting a unidirectional pulse output current, by the adapter, to charge a battery in the mobile terminal.

In combination with the fifth aspect, in a first implementation of the fifth aspect, the method further includes: adopting, by the adapter, a unidirectional pulse charging voltage to perform a quick charging on the battery.

In a sixth aspect, a charge method is provided. The method includes: after a mobile terminal is coupled with an adapter via a charging interface, receiving, by the mobile terminal, a unidirectional pulse output current from the adapter so as to charge a battery in the mobile terminal.

In combination with the sixth aspect or the above implementation, in a first implementation of the sixth aspect, the method further includes: receiving, by the mobile terminal, a unidirectional pulse output voltage from the adapter so as to charge the battery in the mobile terminal.

In a seventh aspect, an adapter is provided. The adapter includes a charging circuit. The charging circuit is configured to adopt a unidirectional pulse output current to charge a battery in a mobile terminal, after the adapter is coupled with the mobile terminal via a charging interface.

In combination with the seventh aspect, in a first implementation of the seventh aspect, the charging circuit is further configured to adopt a unidirectional pulse charging voltage to perform a quick charge on the battery.

In an eighth aspect, a mobile terminal is provided. The mobile terminal is configured to receive a unidirectional pulse output current from an adapter so as to charge a battery in the mobile terminal, after the mobile terminal is coupled with the adapter.

In combination with the eighth aspect, in a first implementation of the eighth aspect, the mobile terminal is further configured to receive a unidirectional pulse output voltage from the adapter so as to charge the battery in the mobile terminal.

In some implementations, the charging interface may be a common USB interface, or may be a micro USB interface, or other kinds of charging interfaces. Taking the USB interface as an example, the power wire in the USB interface may include a Vbus wire and a ground wire. The data wire in the charging interface may include at least one of a D+ wire and a D- wire in the charging interface.

In some implementations, performing a quick charge on the battery may refer to charging the battery in the quick charging mode.

In some implementations, during the quick charge, a peak value of an initial waveform (for example, the first waveform, or first several waveforms) of the output current of the adapter is equal to a current value of the charging current corresponding to the quick charging mode.

In some implementations, during the quick charge, a mean value of an initial waveform of the output current is equal to a current value of the charging current corresponding to the quick charging mode.

In some implementations, the quick charge (or the charging process) includes a current falling process. During the current falling process, a peak value of a latter one in two adjacent waveforms of the output current is less than that of a former one in the two adjacent waveforms. In addition, the quick charge (or the charging process) may further include an initial charging process. During the initial charging process, a waveform of the output current of the adapter may remain constant.

In some implementations, the quick charge (or the charging process) includes a current falling process. The current falling process is divided into a plurality of stages including a first stage and a second stage adjacent to the first stage, in which the first stage is earlier than the second stage, a waveform of the output current remains constant within each of the plurality of stages, waveforms of the output current within different stages of the plurality of stages are different, a peak value of a waveform of the output current within the second stage is less than that of a waveform of the output current within the first stage. In addition, the quick charge (or the charging process) may further include an initial charging process. During the initial charging process, a waveform of the output current of the adapter may remain constant.

In some implementations, during the quick charge, a peak value of an initial waveform of the output voltage is equal to a voltage value of the charging voltage corresponding to the quick charging mode.

In some implementations, during the quick charge, a mean value of an initial waveform of the output voltage is equal to a voltage value of the charging voltage corresponding to the quick charging mode.

In some implementations, the unidirectional pulse output current is a current outputted from a rectifying circuit in the adapter without a filtering. Specifically, the adapter may include a rectifying circuit, but not include a filter circuit or not include an electrolytic capacitor in the filter circuit. That is, output current at an output terminal of the adapter may be used as the output current of the adapter directly without filtering.

In some implementations, a frequency of the pulse current outputted from the adapter is same with a rated frequency of an alternating current power supply grid, for example, may be frequently-used 50Hz and 60Hz.

In some implementations, a waveform period of the unidirectional pulse output current (or output voltage) is constant.

In some implementations, the unidirectional pulse output current (or output voltage) is half-wave current (or half-wave voltage). Further, the half-wave current (or half-wave voltage) may be sine half-wave current (or sine half-wave voltage).

In some implementations, the unidirectional pulse output current (or voltage) may be half-wave current (or voltage) with a same frequency as that at an alternating current (AC) terminal of the rectifying circuit.

In the present disclosure, the adapter communicates with the mobile terminal and adopts unidirectional pulse output current to charge the mobile terminal, such that the service life of the battery is prolonged.

### BRIEF DESCRIPTION OF THE DRAWINGS

In order to make technique solutions according to embodiments of the present disclosure more apparent, drawings needed to be used in descriptions of the embodiments will be illustrated in the following. Obviously, the drawings to be illustrated in the following only represent some embodiments of the present disclosure, and other drawings can be obtained according these drawings by those having ordinary skills in the related art without making creative labors.
Fig. 1 is a block diagram of an internal structure of an adapter in the related art.
Fig. 2 is a schematic diagram of a waveform of unidirectional pulse current.
Fig. 3 is a schematic diagram of a quick charging process according to an embodiment of the present disclosure.
Fig. 4 is a schematic flow chart of a quick charging process according to an embodiment of the present disclosure.
Fig. 5 is a schematic diagram of a waveform of unidirectional pulse output current.
Fig. 6 is a schematic diagram of a waveform of unidirectional pulse output current.
Fig. 7 is a block diagram of an adapter according to an embodiment of the present disclosure.
Fig. 8 is a block diagram of a mobile terminal according to an embodiment of the present disclosure.

### DETAILED DESCRIPTION

In the related art, most adapters are non-intelligent adapters which simply convert the mains voltage into working voltage suitable for charging a battery of a mobile terminal. In order to improve safety and charging speed during the charging process, embodiments of the present disclosure may adopt an intelligent adapter, for example, the adapter may be configured with a micro controller unit (MCU) internally. The MCU may communicate with a mobile terminal, so as to negotiate with the mobile terminal about a charging mode and charging parameters (such as, charging current, charging voltage) and to control the charging process.

The charging mode supported by the adapter and/or the mobile terminal may include a conventional charging mode and a quick charging mode. The charging speed in the quick charging mode is greater than that in the conventional charging mode (for example, charging current in the quick charging mode is greater than that in the conventional charging mode). Generally, the conventional charging mode may be understood as a charging mode in which a rated output voltage is 5V and a rated output current is less than or equal to 2.5A. In addition, in the conventional charging mode, output ports D+ and D- of the adapter may be short-circuited. However, the situation in the quick charging mode according to the present disclosure is different. In the quick charging mode according to the present disclosure, the adapter may employ the D+ and D- output ports to conduct communication and data exchange with the mobile terminal. The charging current in the quick charging mode may be greater than 2.5A, for example, may be 4.5A or more. However, the conventional quick charging mode is not limited in the present disclosure. As long as the adapter supports two charging modes and the charging speed (or current) in one charging mode is greater than that in the other charging mode, the charging mode with a slower charging speed may be configured as the conventional charging mode.

In order to initiate and adopt the quick charging mode, the adapter may perform a quick charging communication process with the mobile terminal, for example, by one or more handshakes, so as to realize a quick charge of the battery. The quick charging communication process and respective stages contained in the quick charging process will be described below in detail with reference to Fig. 3. It should be understood that, the communication steps or operations illustrated in Fig. 3 are merely exemplary. Other operations or modifications of respective operations illustrated in Fig. 3 may be implemented in embodiments of the present disclosure. In addition, respective steps in Fig. 3 may be executed in an order different from that presented in Fig. 3, and it is unnecessary to execute all the operations illustrated in Fig. 3.

Fig. 3 is a schematic diagram of a quick charging process according to an embodiment of the present disclosure.

As illustrated in Fig. 3, the quick charging process may include five stages.

### Stage 1:

The mobile terminal may detect a type of the adapter through the D+ and D-. If it is detected that the adapter is a non-USB-type charging device, current absorbed by the mobile terminal may be greater than a preset current threshold I2 (for example, 1A). If the adapter detects that current outputted from the adapter is greater than or equal to 12 within a preset time period (for example, a continuous time period T1), the adapter considers that the terminal has completed identifying the type of the adapter, and then initiates handshake communication between the adapter and the mobile terminal, and sends an instruction 1 to ask the terminal whether to initiate the quick charging mode (or flash charging).

If the adapter receives a reply instruction indicating that the mobile terminal does not agree to initiate the quick charging mode from the mobile terminal, then the output current of the adapter is detected again. If the output current of the adapter is still greater than or equal to 12, then the adapter sends a request for asking the mobile terminal whether to initiate the quick charging mode again, and the above steps in stage 1 are repeated, until the mobile terminal returns a reply indicating that the mobile terminal agrees to initiate the quick charging mode or the output current of the adapter is no longer greater than or equal to 12.

After the mobile terminal agrees to initiate the quick charging mode, the quick charging mode is initiated, and then the quick charging communication process goes into stage 2.

### Stage 2:

For the output voltage of the adapter, there may be several grades. The adapter sends an instruction 2 to the mobile terminal for asking the mobile terminal whether the output voltage of the adapter matches (or suitable, i.e., suitable to be the charging voltage in the quick charging mode).

If the mobile terminal returns a reply indicating that the output voltage of the adapter is higher, lower or suitable, for example the adapter receives a feedback indicating that the output voltage of the adapter is higher or lower from the mobile terminal, then the adapter adjusts the output voltage of the adapter by one grade, and sends the instruction 2 to the mobile terminal again for asking the mobile terminal whether the output voltage of the adapter matches.

The above steps in stage 2 are repeated, until the mobile terminal returns a reply indicating that the output voltage of the adapter is at a matching grade, and then the quick charging communication process goes into stage 3.

### Stage 3:

After the adapter receives a feedback indicating that the output voltage of the adapter matches from the mobile terminal, the adapter sends an instruction 3 to the mobile terminal for inquiring a maximum charging current currently supported by the mobile terminal, the mobile terminal returns the maximum charging current currently supported by itself to the adapter, and then the quick charging communication process goes into stage 4.

### Stage 4:

The adapter receives a feedback indicating the maximum charging current currently supported by the mobile terminal from the mobile terminal, and then the adapter may configure the output current thereof as a specified value and output the current. Then, the quick charging communication process goes into a constant current stage.

### Stage 5:

When the quick charging communication process goes into the constant current stage, the adapter sends an instruction 4 at intervals to the mobile terminal for inquiring a voltage of the battery, the mobile terminal may feedback the voltage of the battery in the mobile terminal to the adapter, and the adapter may judge, according to the feedback indicating the voltage of the battery in the mobile terminal from the mobile terminal, whether a poor contact occurs in the USB interface or whether to decrease the charging current value of the mobile terminal. If the adapter determines that the poor contact occurs in the USB interface, the adapter sends an instruction 5, and then the adapter is reset such that the quick charging communication process goes into stage 1.

In an embodiment, in stage 1, when the mobile terminal replies to the instruction 1, data in the reply instruction may carry data (or information) on the path impedance of the mobile terminal, and the data on the path impedance of the mobile terminal may be used in stage 5 to judge whether the poor contact occurs in the USB interface.

In an embodiment, in stage 2, the time period from when the mobile terminal agrees to initiate the quick charging mode to when the adapter adjusts the voltage to a suitable value may be controlled to be in a certain range, and if the time period exceeds a preset period, the mobile terminal may determine that a request exception occurs and then the mobile terminal is reset quickly.

In an embodiment, in stage 2, the mobile terminal may return a feedback indicating that the output voltage of the adapter is suitable to the adapter when the output voltage of the adapter is adjusted to a value which is higher than the voltage of the battery by Δ V ( Δ V is about 200-500mV).

In an embodiment, in stage 4, the adjusting speed of the output current value of the adapter may be controlled to be in a certain range, such that an unusual interruption of the quick charge due to the too fast adjusting speed can be avoided.

In an embodiment, in stage 5, i.e., the constant current stage, the variation amplitude of the output current value of the adapter may be controlled to be within 5%.

In an embodiment, in stage 5, the adapter monitors the impedance of a charging loop in real time, i.e., the adapter monitors the impedance of the entire charging loop by measuring the output voltage of the adapter, the charging current and the read voltage of the battery in the terminal. If detected impedance of the charging loop > path impedance of the terminal + impedance of the quick charging data wire, it may be considered that a poor contact occurs in the USB interface, and then the quick charge is reset.

In an embodiment, after the quick charging mode is initiated, the time interval of communications between the adapter and the mobile terminal may be controlled to be in a certain range, such that a reset of quick charge can be avoided.

In an embodiment, the termination of the quick charging mode (or quick charging process) may include a recoverable termination or an unrecoverable termination.

For example, if the mobile terminal detects that the battery is charged fully or a poor contact occurs in the USB interface, the quick charge is terminated and reset, and the quick charging communication process goes into stage 1. If the mobile terminal does not agree to initiate the quick charging mode, the quick charging communication process would not go into stage 2, and this termination of the quick charging process may be considered as an unrecoverable termination.

For example, if an exception occurs in the communication between the mobile terminal and the adapter, the quick charge is terminated and reset, and the quick charging communication process goes into stage 1. After requirements for stage 1 are met, the mobile terminal agrees to initiate the quick charging mode to recover the quick charging process, and this termination of the quick charging process may be considered as a recoverable termination.

For example, if the mobile terminal detects that an exception occurs in the battery, the quick charging is terminated and reset, and the quick charging communication process goes into stage 1. After the quick charging communication process goes into stage 1, the mobile terminal does not agree to initiate the quick charging mode. Till the battery returns to normal and the requirements for stage 1 are met, the mobile terminal agrees to initiate the quick charging mode to recover the quick charging process, and this termination of the quick charging process may be considered as a recoverable termination.

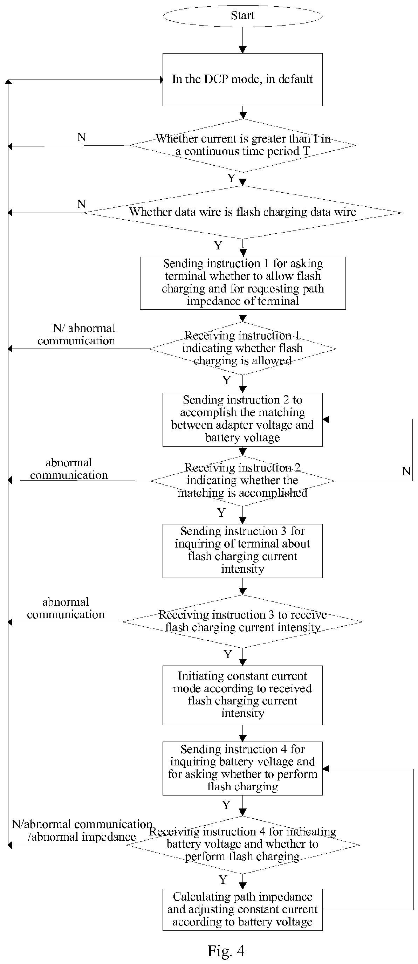

An example of quick charging process will be described below with reference to Fig. 4. The whole process illustrated in Fig. 4 substantially corresponds to the process illustrated in Fig. 3, which is not described herein.

It can be seen from Fig. 4 that, the adapter is in a dedicated charging port (DCP) mode (corresponding to the conventional charging mode, D+ and D- may be short-circuited in this case) at first, and charges the mobile terminal. Before sending the instruction 1, the adapter may judge whether the data wire is a quick charging data wire. There may be many judging methods. For example, an identification circuit is added into the data wire, and the adapter identifies whether the data wire is the quick charging data wire by conducting information interaction with the identification circuit. In addition, it should be noted that, in the entire quick charging process, when a communication exception or an impedance exception occurs, the adapter may quit the quick charging process or may be reset.

The quick charging process between the adapter and the mobile terminal are described above in detail with reference to Fig. 3 and Fig. 4. In order to support the above mentioned quick charging process, the internal structure of the adapter needs to be adjusted, some new components and circuits including the MCU are introduced, which may cause increased bulk of the adapter. In order to decrease the bulk of the adapter, optimize the circuit structure in the adapter and improve the charging performance, the internal filter circuit may be removed from the adapter, or the electrolytic capacitor with a great bulk in the filter circuit may be removed.

In this way, after the adapter acquires the current from the mains supply and rectifies the current, the adapter directly outputs unidirectional pulse current/voltage (for example, half-wave voltage/current with the same frequency as that at the AC terminal, which may be referred to as steamed buns voltage/current) at the output terminal without filtering of the electrolytic capacitor. The unidirectional pulse current/voltage has the same frequency as the power supply grid, for example, may be frequently-used 50Hz or 60 Hz, however, the present disclosure is not limited thereto.

The quick charging communication process is described above with reference to Fig. 3 and Fig. 4. Before the adapter adopts the quick charging mode, the adapter may charge the battery in the mobile terminal in the conventional charging mode (which may be referred to as standard charge). In the conventional charging mode, the output current/voltage of the adapter may be the above mentioned unidirectional pulse current/voltage, since the charging performance in the conventional charging mode may be improved in this way. Certainly, as an implementation, the adapter may filter the current in the conventional charging mode, so as to be compatible with the prior art. For example, in general, the filter circuit includes an electrolytic capacitor and a common capacitor (such as solid capacitor) in parallel. Since the electrolytic capacitor has a great bulk, the electrolytic capacitor in the adapter may be removed and a capacitor with low capacitance may be reserved, so as to decrease the volume of the adapter. When the conventional charging mode is adopted, a branch circuit having the capacitor may be controlled to be switched on for filtering the current, such that the output with small power is stable. When the quick charging mode is adopted, the branch circuit having the common capacitor may be controlled to be switched off to avoid damage to the capacitor due to the standard-exceeding ripple current in the capacitor, such that the unidirectional pulse current is directly outputted without filtering.

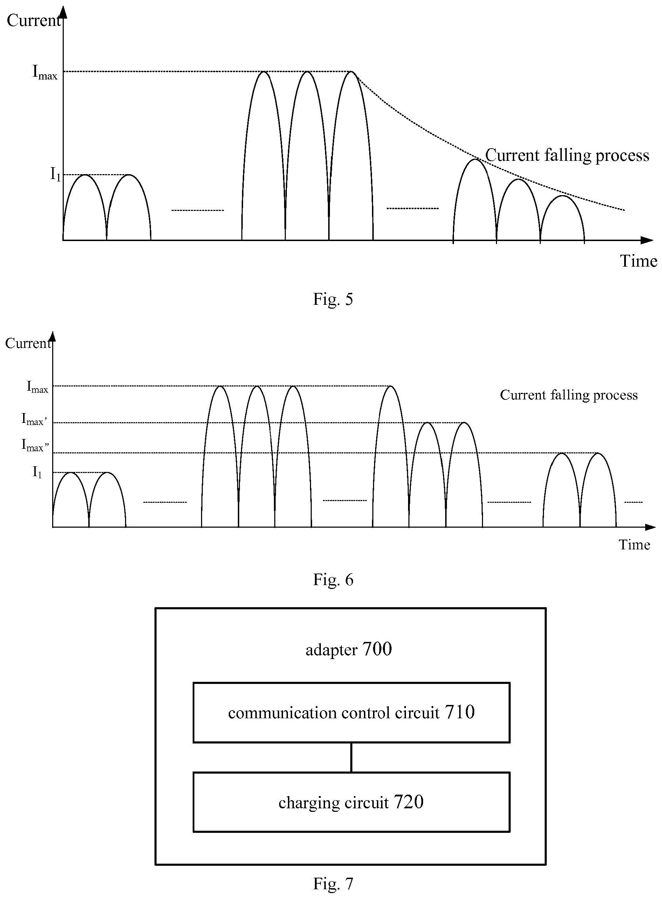

Fig. 5 and Fig. 6 illustrate an example of a waveform of output current of the adapter during a process changing from the conventional charging mode to the quick charging mode. It should be understood that, the waveform of voltage may be similar to that of current, which is not described hereinafter.

In Fig. 5 and Fig. 6, I₁ represents a peak value of a waveform of current in the conventional charging mode, and Iₘₐₓ represents a peak value of a waveform of initial current in the quick charging mode. In an embodiment, Iₘₐₓ may be related to remaining electric quantity in the battery or the voltage of the battery. For example, if the remaining electric quantity in the battery is low (for example, less than 10%), Iₘₐₓ may be high, for example 4.5A; if the remaining electric quantity in the battery is high (for example, higher than 80%), Iₘₐₓ may be low, for example 3A. The quick charging process may include an initial process and a current falling process (here, refers to the entire quick charging process, certainly, if the remaining electric quantity in the battery is high, the quick charging process may go into the current falling process directly). During the initial process, the adapter may remain the current at Iₘₐₓ. During the current falling process, the adapter may pull down the output current in a continuous or staged way. For example, in a current falling way illustrated in Fig. 5, the waveform of the output current in a latter cycle has a peak value less than the peak value in a former cycle. In the current falling way illustrated in Fig. 6, the current falling process is divided into a plurality of stages. In each stage, the waveform of current remains constant, but a peak value of the waveform of the output current in a latter stage is less than that of the waveform in a former stage. Each waveform of current may occupy the same time period, and the frequency of the current waveform may be frequently-used 50Hz or 60Hz, which is synchronous with the frequency of the power supply grid. If the current reaches Iₘₐₓ, it indicates that the quick charge goes into stage 5 illustrated in Fig. 3. After the quick charge goes into stage 5, the adapter may interact the electric quantity of the battery (or voltage of the battery) with the mobile terminal, so as to guide the proceeding of current falling process.

The charge method according to embodiments of the present disclosure is described above in detail with reference to Figs. 1-6. The adapter and the mobile terminal according to embodiments of the present disclosure will be described below in detail with reference to Figs. 7-8.

Fig. 7 is a block diagram of an adapter according to an embodiment of the present disclosure. It should be understood that, the adapter 700 in Fig. 7 may execute the above mentioned steps executable by the adapter, which are not described herein for simplicity. The adapter 700 in Fig. 7 includes a communication control circuit 710 and a charging circuit 720. The communication control circuit 710 is configured to: communicate with a mobile terminal to determine a charging mode, after the adapter is coupled with the mobile terminal via a charging interface, in which a power wire in the charging interface is configured to charge a battery, a data wire in the charging interface is used for communication between the adapter and the mobile terminal, and the charging mode includes a quick charging mode and a conventional charging mode, in which a charging speed in the quick charging mode is greater than that in the conventional charging mode; communicate with the mobile terminal to determine a charging current corresponding to the quick charging mode, under a situation of determining to charge the battery in the quick charging mode; and adopt, according to the charging current corresponding to the quick charging mode, a unidirectional pulse output current to perform a quick charge on the battery via the charging circuit 720.

In an embodiment, during the quick charge, a peak value of an initial waveform of the unidirectional pulse output current is equal to a current value of the charging current corresponding to the quick charging mode.

In an embodiment, during the quick charge, a mean value of an initial waveform of the unidirectional pulse output current is equal to a current value of the charging current corresponding to the quick charging mode.

In an embodiment, the quick charge includes a current falling process. During the current falling process, a peak value of a latter one in two adjacent waveforms of the unidirectional pulse output current is less than that of a former one in the two adjacent waveforms.

In an embodiment, the quick charge includes a current falling process. The current falling process is divided into a plurality of stages including a first stage and a second stage adjacent to the first stage. The first stage is earlier than the second stage. A waveform of the unidirectional pulse output current remains constant within each of the plurality of stages. A peak value of a waveform of the unidirectional pulse output current in the second stage is less than that of a waveform of the unidirectional pulse output current in the first stage.

In an embodiment, the communication control circuit 710 is further configured to communicate with the mobile terminal to determine a charging voltage corresponding to the quick charging mode, under a situation that the adapter 700 determines to charge the battery in the quick charging mode, and to adopt, according to the charging voltage corresponding to the quick charging mode, a unidirectional pulse output voltage to perform a quick charge on the battery.

In an embodiment, during the quick charge, a peak value of an initial waveform of the unidirectional pulse output voltage is equal to a voltage value of the charging voltage corresponding to the quick charging mode.

In an embodiment, during the quick charge, a mean value of an initial waveform of the unidirectional pulse output voltage is equal to a voltage value of the charging voltage corresponding to the quick charging mode.

In an embodiment, the unidirectional pulse output current is a current outputted from a rectifying circuit in the adapter 700 without a filtering.

In an embodiment, the frequency f of the unidirectional pulse output current of the adapter 700 satisfies: 50Hz≤f≤60Hz.

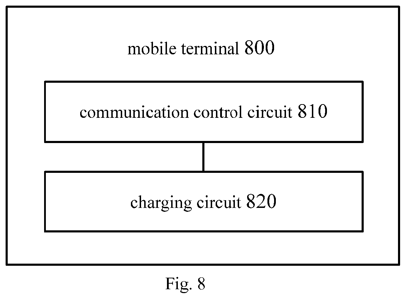

Fig. 8 is a block diagram of a mobile terminal according to an embodiment of the present disclosure. It should be understood that, the mobile terminal 800 in Fig. 8 may execute the above mentioned steps executable by a mobile terminal, which are not described herein for simplicity. The mobile terminal 800 includes a communication control circuit 810 and a charging circuit 820. The communication control circuit 810 is configured to: communicate with the adapter to determine a charging mode, after the mobile terminal is coupled with an adapter via a charging interface, in which a power wire in the charging interface is configured to charge a battery, a data wire in the charging interface is used for communication between the mobile terminal 800 and the adapter, and the charging mode includes a quick charging mode and a conventional charging mode, in which a charging speed in the quick charging mode is greater than that in the common charging mode; communicate with the adapter to determine a charging current corresponding to the quick charging mode, under a situation of determining to charge the battery in the quick charging mode; and receive a unidirectional pulse output current from the adapter so as to perform a quick charge on the battery via the charging circuit, in which the unidirectional pulse output current is determined by the adapter according to the charging current corresponding to the quick charging mode.

In an embodiment, during the quick charge, a peak value of an initial waveform of the unidirectional pulse output current is equal to a current value of the charging current corresponding to the quick charging mode.

In an embodiment, during the quick charge, a mean value of an initial waveform of the unidirectional pulse output current is equal to a current value of the charging current corresponding to the quick charging mode.

In an embodiment, the quick charge includes a current falling process. During the current falling process, a peak value of a latter one in two adjacent waveforms of the unidirectional pulse output current is less than that of a former one in the two adjacent waveforms.

In an embodiment, the quick charge includes a current falling process. The current falling process is divided into a plurality of stages including a first stage and a second stage adjacent to the first stage. The first stage is earlier than the second stage. A waveform of the unidirectional pulse output current within each of the plurality of stages remains constant. A peak value of a waveform of the unidirectional pulse output current in the second stage is less than that of a waveform of the unidirectional pulse output current in the first stage.

In an embodiment, the communication control circuit 810 is further configured to communicate with the adapter to determine a charging voltage corresponding to the quick charging mode, under a situation of determining to charge the battery in the quick charging mode, and to receive a unidirectional pulse output voltage from the adapter so as to perform a quick charge on the battery, in which the unidirectional pulse output voltage is determined by the adapter according to the charging voltage corresponding to the quick charging mode.

In an embodiment, during the quick charge, a peak value of an initial waveform of the unidirectional pulse output voltage is equal to a voltage value of the charging voltage corresponding to the quick charging mode.

In an embodiment, during the quick charge, a mean value of an initial waveform of the unidirectional pulse output voltage is equal to a voltage value of the charging voltage corresponding to the quick charging mode.

In an embodiment, the unidirectional pulse output current is a current outputted from a rectifying circuit in the adapter without a filtering.

In an embodiment, the frequency f of the unidirectional pulse output current of the adapter 700 satisfies: 50Hz≤f≤60Hz.

Those skilled in the art can be aware that, units and algorithm steps in respective examples described with reference to embodiments disclosed in the present disclosure can be realized by electronic hardware or combination of computer software and electronic hardware. Executing these functions in hardware or software depends on particular applications and design constraint conditions of the technical solutions. Technology professionals can use different methods to realize the described functions for each particular application, which should be regarded as being within the scope of the present disclosure.

Those skilled in the art can understand clearly that, for convenience and simplicity of description, specific working process of the above system, devices and units may refer to corresponding process in the above method embodiments, which will not be elaborated herein.

It should be understood that, the system, devices and method disclosed in several embodiments provided by the present disclosure can be realized in any other manner. For example, the device embodiments described above can be merely exemplary, for example, the units are just divided according to logic functions. In practical implementation, the units can be divided in other manners, for example, multiple units or components can be combined or integrated into another system, or some features can be omitted or not executed. In addition, the mutual coupling or direct coupling or communication connection described or discussed can be via some interfaces, and indirect coupling or communication connection between devices or units may be electrical, mechanical or of other forms.

The units illustrated as separate components can be or not be separated physically, and components described as units can be or not be physical units, i.e., can be located at one place, or can be distributed onto multiple network units. It is possible to select some or all of the units according to actual needs, for realizing the objective of embodiments of the present disclosure.

In addition, respective functional units in respective embodiments of the present disclosure can be integrated into one processing unit, or can be present as separate physical entities. It is also possible that two or more than two units are integrated into one unit.

If the functions are realized in form of functional software units and are sold or used as separate products, they can be stored in a computer readable storage medium. Based on this understanding, the parts of the technical solutions or the essential parts of the technical solutions (i.e. the parts making a contribution to the related art) can be embodied in form of software product, which is stored in a storage medium, and includes several instruction used for causing a computer device (for example, a personal computer, a server or a network device) to execute all or part of steps in the methods described in respective embodiments of the present disclosure. The above storage medium may be any medium capable of storing program codes, including a USB flash disk, a mobile hard disk, a Read-Only Memory (ROM), a Random Access Memory (RAM), a disc, or a light disk.

The forgoing description is only directed to preferred embodiments of the present disclosure, but not used to limit the present disclosure. All modifications, equivalents, variants and improvements made within the scope of the present disclosure, as defined by the appended claims.

## Claims

1. A charge method, comprising:
after an adapter is coupled with a mobile terminal via a charging interface, communicating, by the adapter, with the mobile terminal to determine a charging mode, wherein a power wire in the charging interface is configured to charge a battery, a data wire in the charging interface is used for communication between the adapter and the mobile terminal, the adapter supports two charging modes comprising a quick charging mode and a conventional charging mode, in which a charging speed in the quick charging mode is greater than that in the conventional charging mode;
under a situation of determining to charge the battery in the quick charging mode, communicating, by the adapter, with the mobile terminal to determine a charging current corresponding to the quick charging mode; **characterized by**
adopting, by the adapter according to the charging current corresponding to the quick charging mode, a unidirectional pulse output current to perform a quick charge on the battery,
wherein the quick charge comprises a current falling process, the current falling process is divided into a plurality of stages comprising a first stage and a second stage adjacent to the first stage, in which the first stage is earlier than the second stage, each stage comprises a plurality of pulses, a waveform of each pulse is same to each other within each stage, and a peak value of waveform of each pulse in the second stage is less than that in the first stage.

2. The method according to claim 1, wherein, during the quick charge, a peak value of an initial waveform of the unidirectional pulse output current is equal to a current value of the charging current corresponding to the quick charging mode, or a mean value of an initial waveform of the unidirectional pulse output current is equal to a current value of the charging current corresponding to the quick charging mode.

3. The method according to claim 1 or 2, wherein, in the current falling process, a peak value of a latter one in two adjacent waveforms of the unidirectional pulse output current is less than that of a former one in the two adjacent waveforms.

4. The method according to any one of claims 1-3, wherein, before adopting, by the adapter according to the charging current corresponding to the quick charging mode, a unidirectional pulse output current to perform a quick charge on the battery, the method further comprises:
under a situation that the adapter determines to charge the battery in the quick charging mode, communicating, by the adapter, with the mobile terminal to determine a charging voltage corresponding to the quick charging mode; and
adopting, by the adapter according to the charging voltage corresponding to the quick charging mode, a unidirectional pulse output voltage to perform a quick charge on the battery.

5. The method according to claim 4, wherein, during the quick charge, a peak value of an initial waveform of the unidirectional pulse output voltage is equal to a voltage value of the charging voltage corresponding to the quick charging mode, or a mean value of an initial waveform of the unidirectional pulse output voltage is equal to a voltage value of the charging voltage corresponding to the quick charging mode.

6. The method according to any one of claims 1-5, wherein, the unidirectional pulse output current is a current outputted from a rectifying circuit in the adapter without a filtering.

7. The method according to any one of claims 1-6, wherein, a pulse frequency of the unidirectional pulse output current is same with a frequency of an alternating current power supply grid.

8. An adapter (700), comprising a communication control circuit (710) and a charging circuit (720), wherein,
the communication control circuit (710) is configured to:
communicate with a mobile terminal (800) to determine a charging mode, after the adapter (700) is coupled with the mobile terminal (800) via a charging interface, wherein a power wire in the charging interface is configured to charge a battery, a data wire in the charging interface is used for communication between the adapter (700) and the mobile terminal (800), the adapter (700) supports two charging modes comprising a quick charging mode and a conventional charging mode, in which a charging speed in the quick charging mode is greater than that in the conventional charging mode;
communicate with the mobile terminal (800) to determine a charging current corresponding to the quick charging mode, under a situation of determining to charge the battery in the quick charging mode; further **characterized by** being configured to adopt, according to the charging current corresponding to the quick charging mode, a unidirectional pulse output current to perform a quick charge on the battery via the charging circuit,
wherein the quick charge comprises a current falling process, the current falling process is divided into a plurality of stages comprising a first stage and a second stage adjacent to the first stage, in which the first stage is earlier than the second stage, each stage comprises a plurality of pulses, a waveform of each pulse is same to each other within each stage, and a peak value of waveform of each pulse in the second stage is less than that in the first stage.

9. The adapter (700) according to claim 8 , wherein, during the quick charge, a peak value of an initial waveform of the unidirectional pulse output current is equal to a current value of the charging current corresponding to the quick charging mode, or a mean value of an initial waveform of the unidirectional pulse output current is equal to a current value of the charging current corresponding to the quick charging mode.

10. The adapter (700) according to claim 8, wherein, in the current falling process, a peak value of a latter one in two adjacent waveforms of the unidirectional pulse output current is less than that of a former one in the two adjacent waveforms.

11. The adapter (700) according to any one of claims 8-10, wherein, the communication control circuit (710) is further configured to:
communicate with the mobile terminal (800) to determine a charging voltage corresponding to the quick charging mode, under a situation that the adapter (700) determines to charge the battery in the quick charging mode; and
adopt, according to the charging voltage corresponding to the quick charging mode, a unidirectional pulse output voltage to perform a quick charge on the battery.

12. The adapter (700) according to claim 11, wherein, during the quick charge, a peak value of an initial waveform of the unidirectional pulse output voltage is equal to a voltage value of the charging voltage corresponding to the quick charging mode, or a mean value of an initial waveform of the unidirectional pulse output voltage is equal to a voltage value of the charging voltage corresponding to the quick charging mode.

13. The adapter (700) according to any one of claims 8-12, wherein, the unidirectional pulse output current is a current outputted from a rectifying circuit in the adapter (700) without a filtering, and/or a pulse frequency of the unidirectional pulse output current is same with a frequency of an alternating current power supply grid.

## Patentansprüche

1. Ladeverfahren, umfassend:
nachdem ein Adapter über eine Ladeschnittstelle mit einem mobilen Endgerät gekoppelt wird, Kommunizieren mit dem mobilen Endgerät durch den Adapter, um einen Lademodus zu bestimmen, wobei eine Stromleitung in der Ladeschnittstelle zum Laden einer Batterie ausgelegt ist, eine Datenleitung in der Ladeschnittstelle zur Kommunikation zwischen dem Adapter und dem mobilen Endgerät verwendet wird und der Adapter zwei Lademodi unterstützt, die einen Schnelllademodus und einen herkömmlichen Lademodus umfassen, wobei eine Ladegeschwindigkeit im Schnelllademodus größer als im herkömmlichen Lademodus ist;
unter einer Situation des Bestimmens, die Batterie im Schnelllademodus zu laden, Kommunizieren mit dem mobilen Endgerät durch den Adapter, um einen dem Schnelllademodus entsprechenden Ladestrom zu bestimmen; **gekennzeichnet durch**
Verwenden eines unidirektionalen Impulsausgangsstroms zum Ausführen eines Schnellladens an der Batterie durch den Adapter gemäß dem Ladestrom, der dem Schnelllademodus entspricht,
wobei das Schnellladen einen Stromabfallprozess umfasst, der Stromabfallprozess in mehrere Phasen unterteilt ist, die eine erste Phase und eine an die erste Phase angrenzende zweite Phase umfassen, wobei die erste Phase früher als die zweite Phase ist, jede Phase mehrere Impulse umfasst, eine Wellenform jedes Impulses innerhalb jeder Phase einander gleich ist und ein Spitzenwert der Wellenform jedes Impulses in der zweiten Phase kleiner als in der ersten Phase ist.

2. Verfahren nach Anspruch 1, wobei während des Schnellladens ein Spitzenwert einer anfänglichen Wellenform des unidirektionalen Impulsausgangsstroms gleich einem Stromwert des Ladestroms ist, der dem Schnelllademodus entspricht, oder ein Mittelwert einer anfänglichen Wellenform des unidirektionalen Impulsausgangsstroms gleich einem Stromwert des Ladestroms ist, der dem Schnelllademodus entspricht.

3. Verfahren nach Anspruch 1 oder 2, wobei in dem Stromabfallprozess ein Spitzenwert einer letzteren von zwei angrenzenden Wellenformen des unidirektionalen Impulsausgangsstroms kleiner als der einer ersteren der zwei angrenzenden Wellenformen ist.

4. Verfahren nach einem der Ansprüche 1-3, wobei das Verfahren, vor dem Verwenden eines unidirektionalen Impulsausgangsstroms zum Ausführen eines Schnellladens an der Batterie durch den Adapter gemäß dem Ladestrom, der dem Schnelllademodus entspricht, ferner Folgendes umfasst:
unter einer Situation, dass der Adapter bestimmt, die Batterie im Schnelllademodus zu laden, Kommunizieren mit dem mobilen Endgerät durch den Adapter, um eine dem Schnelllademodus entsprechende Ladespannung zu bestimmen; und
Verwenden einer unidirektionalen Impulsausgangsspannung zum Ausführen einer Schnellladung an der Batterie durch den Adapter gemäß der dem Schnelllademodus entsprechenden Ladespannung.

5. Verfahren nach Anspruch 4, wobei während der Schnellladung ein Spitzenwert einer anfänglichen Wellenform der unidirektionalen Impulsausgangsspannung gleich einem dem Schnelllademodus entsprechenden Spannungswert der Ladespannung ist oder ein Mittelwert einer anfänglichen Wellenform der unidirektionalen Impulsausgangsspannung gleich einem dem Schnelllademodus entsprechenden Spannungswert der Ladespannung ist.

6. Verfahren nach einem der Ansprüche 1-5, wobei der unidirektionale Impulsausgangsstrom ein Strom ist, der von einer Gleichrichtschaltung in dem Adapter ohne Filterung ausgegeben wird.

7. Verfahren nach einem der Ansprüche 1-6, wobei eine Impulsfrequenz des unidirektionalen Impulsausgangsstroms mit einer Frequenz einer Netz-Wechselstromversorgung übereinstimmt.

8. Adapter (700), der eine Kommunikationssteuerschaltung (710) und eine Ladeschaltung (720) umfasst, wobei
die Kommunikationssteuerschaltung (710) ausgelegt ist zum
Kommunizieren mit einem mobilen Endgerät (800) zur Bestimmung eines Lademodus, nachdem der Adapter (700) über eine Ladeschnittstelle mit dem mobilen Endgerät (800) gekoppelt wird, wobei eine Stromleitung in der Ladeschnittstelle zum Laden einer Batterie ausgelegt ist, eine Datenleitung in der Ladeschnittstelle zur Kommunikation zwischen dem Adapter (700) und dem mobilen Endgerät (800) verwendet wird und der Adapter (700) zwei Lademodi unterstützt, die einen Schnelllademodus und einen herkömmlichen Lademodus umfassen, wobei eine Ladegeschwindigkeit im Schnelllademodus größer als im herkömmlichen Lademodus ist;
Kommunizieren mit dem mobilen Endgerät (800) zum Bestimmen eines dem Schnelllademodus entsprechenden Ladestroms unter einer Situation des Bestimmens, die Batterie im Schnelllademodus zu laden; ferner **dadurch gekennzeichnet, dass** er ausgelegt ist zum
Verwenden eines unidirektionalen Impulsausgangsstroms zum Ausführen einer Schnellladung an der Batterie über die Ladeschaltung gemäß dem Ladestrom, der dem Schnelllademodus entspricht,
wobei das Schnellladen einen Stromabfallprozess umfasst, der Stromabfallprozess in mehrere Phasen unterteilt ist, die eine erste Phase und eine an die erste Phase angrenzende zweite Phase umfassen, wobei die erste Phase früher als die zweite Phase ist, jede Phase mehrere Impulse umfasst, eine Wellenform jedes Impulses innerhalb jeder Phase einander gleich ist und ein Spitzenwert der Wellenform jedes Impulses in der zweiten Phase kleiner als in der ersten Phase ist.

9. Adapter (700) nach Anspruch 8, wobei während des Schnellladens ein Spitzenwert einer anfänglichen Wellenform des unidirektionalen Impulsausgangsstroms gleich einem Stromwert des Ladestroms ist, der dem Schnelllademodus entspricht, oder ein Mittelwert einer anfänglichen Wellenform des unidirektionalen Impulsausgangsstroms gleich einem Stromwert des Ladestroms ist, der dem Schnelllademodus entspricht.

10. Adapter (700) nach Anspruch 8, wobei in dem Stromabfallprozess ein Spitzenwert einer letzteren von zwei angrenzenden Wellenformen des unidirektionalen Impulsausgangsstroms kleiner als der einer ersteren der zwei angrenzenden Wellenformen ist.

11. Adapter (700) nach einem der Ansprüche 8-10, wobei die Kommunikationssteuerschaltung (710) ferner ausgelegt ist zum
Kommunizieren mit dem mobilen Endgerät (800) zur Bestimmung einer dem Schnelllademodus entsprechenden Ladespannung unter einer Situation, dass der Adapter (700) bestimmt, die Batterie im Schnelllademodus zu laden; und
Verwenden einer unidirektionalen Impulsausgangsspannung zum Ausführen einer Schnellladung an der Batterie gemäß der dem Schnelllademodus entsprechenden Ladespannung.

12. Adapter (700) nach Anspruch 11, wobei während der Schnellladung ein Spitzenwert einer anfänglichen Wellenform der unidirektionalen Impulsausgangsspannung gleich einem dem Schnelllademodus entsprechenden Spannungswert der Ladespannung ist oder ein Mittelwert einer anfänglichen Wellenform der unidirektionalen Impulsausgangsspannung gleich einem dem Schnelllademodus entsprechenden Spannungswert der Ladespannung ist.

13. Adapter (700) nach einem der Ansprüche 8-12, wobei der unidirektionale Impulsausgangsstrom ein Strom ist, der von einer Gleichrichtschaltung in dem Adapter (700) ohne Filterung ausgegeben wird und/oder eine Impulsfrequenz des unidirektionalen Impulsausgangsstroms mit einer Frequenz einer Netz-Wechselstromversorgung übereinstimmt.

## Revendications

1. Procédé de charge, comprenant :
après qu'un adaptateur a été couplé à un terminal mobile par l'intermédiaire d'une interface de charge, la communication, par l'adaptateur, avec le terminal mobile, pour déterminer un mode de charge, un câble d'alimentation dans l'interface de charge étant configuré pour charger une batterie, un câble de données dans l'interface de charge étant utilisé pour la communication entre l'adaptateur et le terminal mobile, l'adaptateur prenant en charge deux modes de charge comprenant un mode de charge rapide et un mode de charge conventionnel, une vitesse de charge au mode de charge rapide étant supérieure à celle du mode de charge conventionnel ;
dans une situation dans laquelle il est déterminé qu'il faut charger la batterie au mode de charge rapide, la communication, par l'adaptateur, avec le terminal mobile, pour déterminer un courant de charge correspondant au mode de charge rapide ; **caractérisé par**
l'adoption, par l'adaptateur, en fonction du courant de charge correspondant au mode de charge rapide, d'un courant de sortie unidirectionnel puisé pour l'exécution d'une charge rapide de la batterie,
la charge rapide comprenant un processus d'abaissement de courant, le processus d'abaissement de courant étant subdivisé en une pluralité d'étapes comprenant une première étape et une deuxième étape contiguë à la première étape, la première étape étant antérieure à la deuxième étape, chaque étape comprenant une pluralité d'impulsions, une forme d'onde de chaque impulsion étant identique à chaque autre dans chaque étape, et une valeur de crête de la forme d'onde de chaque impulsion dans la deuxième étape étant inférieure à celle de la première étape.

2. Procédé selon la revendication 1, dans lequel, pendant la charge rapide, une valeur de crête d'une forme d'onde initiale du courant de sortie unidirectionnel puisé est égale à une valeur de courant du courant de charge correspondant au mode de charge rapide, ou une valeur moyenne d'une forme d'onde initiale du courant de sortie unidirectionnel puisé est égale à une valeur de courant du courant de charge correspondant au mode de charge rapide.

3. Procédé selon la revendication 1 ou 2, dans lequel, dans le processus d'abaissement de courant, une valeur de crête de la dernière de deux formes d'onde adjacentes du courant de sortie unidirectionnel pulsé est inférieure à celle de la première des deux formes d'onde adjacentes.

4. Procédé selon l'une quelconque des revendications 1 à 3, lequel procédé comprenant en outre, avant l'adoption, par l'adaptateur, en fonction du courant de charge correspondant au mode de charge rapide, d'un courant de sortie unidirectionnel pulsé pour l'exécution d'une charge rapide de la batterie :
dans une situation dans laquelle l'adapteur détermine qu'il faut charger la batterie au mode de charge rapide, la communication, par l'adaptateur, avec le terminal mobile, pour déterminer une tension de charge correspondant au mode de charge rapide ; et
l'adoption, par l'adaptateur, en fonction de la tension de charge correspondant au mode de charge rapide, d'une tension de sortie unidirectionnelle pulsée pour l'exécution d'une charge rapide de la batterie.

5. Procédé selon la revendication 4, dans lequel, pendant la charge rapide, une valeur de crête d'une forme d'onde initiale de la tension de sortie unidirectionnelle pulsée est égale à une valeur de tension de la tension de charge correspondant au mode de charge rapide, ou une valeur moyenne d'une forme d'onde initiale de la tension de sortie unidirectionnelle pulsée est égale à une valeur de tension de la tension de charge correspondant au mode de charge rapide.

6. Procédé selon l'une quelconque des revendications 1 à 5, dans lequel le courant de sortie unidirectionnel pulsé est un courant émis par un circuit redresseur dans l'adapteur, sans filtrage.

7. Procédé selon l'une quelconque des revendications 1 à 6, dans lequel une fréquence de pulsation du courant de sortie unidirectionnel pulsé est identique à une fréquence d'un réseau d'alimentation électrique en courant alternatif.

8. Adaptateur (700), comprenant un circuit de commande de communication (710) et un circuit de charge (720), dans lequel
le circuit de commande de communication (710) est configuré pour :
communiquer avec un terminal mobile (800) pour déterminer un mode de charge, après que l'adaptateur (700) a été couplé au terminal mobile (800) par l'intermédiaire d'une interface de charge, un câble d'alimentation dans l'interface de charge étant configuré pour charger une batterie, un câble de données dans l'interface de charge étant utilisé pour la communication entre l'adaptateur (700) et le terminal mobile (800), l'adaptateur (700) prenant en charge deux modes de charge comprenant un mode de charge rapide et un mode de charge conventionnel, une vitesse de charge au mode de charge rapide étant supérieure à celle du mode de charge conventionnel ;
communiquer avec le terminal mobile (800) pour déterminer un courant de charge correspondant au mode de charge rapide, dans une situation dans laquelle il est déterminé qu'il faut charger la batterie au mode de charge rapide ; **caractérisé en outre en ce qu'**il est configuré pour :
adopter, en fonction du courant de charge correspondant au mode de charge rapide, un courant de sortie unidirectionnel pulsé pour l'exécution d'une charge rapide de la batterie par l'intermédiaire du circuit de charge,
la charge rapide comprenant un processus d'abaissement de courant, le processus d'abaissement de courant étant subdivisé en une pluralité d'étapes comprenant une première étape et une deuxième étape contiguë à la première étape, la première étape étant antérieure à la deuxième étape, chaque étape comprenant une pluralité d'impulsions, une forme d'onde de chaque impulsion étant identique à chaque autre dans chaque étape, et une valeur de crête de la forme d'onde de chaque impulsion dans la deuxième étape étant inférieure à celle de la première étape.

9. Adaptateur (700) selon la revendication 8, dans lequel, pendant la charge rapide, une valeur de crête d'une forme d'onde initiale du courant de sortie unidirectionnel pulsé est égale à une valeur de courant du courant de charge correspondant au mode de charge rapide, ou une valeur moyenne d'une forme d'onde initiale du courant de sortie unidirectionnel pulsé est égale à une valeur de courant du courant de charge correspondant au mode de charge rapide.

10. Adaptateur (700) selon la revendication 8, dans lequel, dans le processus d'abaissement de courant, une valeur de crête de la dernière de deux formes d'onde adjacentes du courant de sortie unidirectionnel pulsé est inférieure à celle de la première des deux formes d'onde adjacentes.

11. Adaptateur (700) selon l'une quelconque des revendications 8 à 10, dans lequel le circuit de commande de communication (710) est en outre configuré pour :
communiquer avec le terminal mobile (800) pour déterminer une tension de charge correspondant au mode de charge rapide, dans une situation dans laquelle l'adaptateur (700) détermine qu'il faut charger la batterie au mode de charge rapide ; et
adopter, en fonction de la tension de charge correspondant au mode de charge rapide, une tension de sortie unidirectionnelle pulsée pour l'exécution d'une charge rapide de la batterie.

12. Adaptateur (700) selon la revendication 11, dans lequel, pendant la charge rapide, une valeur de crête d'une forme d'onde initiale de la tension de sortie unidirectionnelle pulsée est égale à une valeur de tension de la tension de charge correspondant au mode de charge rapide, ou une valeur moyenne d'une forme d'onde initiale de la tension de sortie unidirectionnelle pulsée est égale à une valeur de tension de la tension de charge correspondant au mode de charge rapide.

13. Adaptateur (700) selon l'une quelconque des revendications 8 à 12, dans lequel le courant de sortie unidirectionnel pulsé est un courant émis par un circuit redresseur dans l'adapteur (700), sans filtrage, et/ou une fréquence de pulsation du courant de sortie unidirectionnel pulsé est identique à une fréquence d'un réseau d'alimentation électrique en courant alternatif.
